# EUROPEAN PATENT APPLICATION

(11) **EP 4 084 040 A1**
(43) Date of publication of application: **02.11.2022**
(21) Application number: 21171389.6
(22) Date of filing: 29.04.2021
(51) Int. Cl.: H01J 37/32, C23C 14/56, C23C 16/54

(54) **METHOD AND DEVICES FOR PLASMA TREATMENT**

(71) Applicant: voestalpine Stahl GmbH, 4020 Linz (AT)
(72) Inventor: Vanden Brande, Pierre, 6377 Seelisberg (CH)
(74) Representative: Callewaert, Koen

(57) **Abstract**

Method and corresponding device for plasma treating substrates (21) moving along a transport direction (5) through a treatment zone that is delimited in a direction transversal to said transport direction (5) by at least one wall (13) forming a diffuser panel presenting an aperture (23). The plasma is introduced into the treatment zone trough said aperture (23) and is generated by means of a plasma source connecting to the aperture (23). A multipolar cusp magnetic field is generated that extends along said wall (13) and at least partially around the aperture (23) and adjacent to this aperture (23) such that said plasma, entering the treatment zone trough said aperture (23), is distributed along said wall (13) in this treatment zone.

## Description

The invention concerns a device for plasma treatment of substrates. The device comprises a vacuum chamber with a confinement enclosure having a treatment zone and presenting a treatment direction along which substrates to be treated are to be moved through the treatment zone. This treatment zone is delimited in a direction transversal to the treatment direction by lateral walls of the confinement enclosure. At least one of these lateral walls has an opening to allow plasma to enter the treatment zone. The opening connects to a plasma source that is external to the treatment zone such that plasma generated by the plasma source can enter the treatment zone through this opening.

The invention relates, in general to a method and a device for plasma treatment of substrates, in particular cleaning, heating, or coating by plasma enhanced vapor deposition (PECVD). The substrates to be treated by the device or the method of the invention, are, for example, metal products in the form of strips, sheets, wires, girders, plates or profiles presenting all types of cross-sections, etc. The substrates or products can also comprise parts disposed on supports or carried by, for example, metal hooks or baskets. The substrates are transported through the treatment area by means of a transport system such as, for example, a bank of rollers, a conveyor or a monorail transport system.

According to the present invention one or several plasma sources are combined with a magnetic multipolar plasma confinement that is provided at lateral walls of the confinement enclosure. These lateral walls are preferably substantially parallel to the treatment direction and do not cross that direction.

Such a design provides two important advantages compared to other possible combinations: **i)** a better plasma uniformity in the treatment zone along said treatment direction allowing a more uniform treatment of products or substrates moving along the treatment direction, **ii)** a faster decay of the plasma density at the extremities of the plasma confinement area along the treatment direction, allowing the suppression of parasitic discharge outside the plasma confinement area. Parasitic discharges outside of the plasma confinement area are a serious issue in plasma processes where the running product is at the same electric potential as the internal walls of the vacuum chamber, more particularly at ground potential, when an anode is used in the plasma confinement area. This is specifically the case in product etching or PECVD coating with a bias polarization of the product against an anode.

### Prior Art :

The combination of multipolar magnetic cusps (MMC) and plasma sources, in particular inductive sources (see for example: US 8,436,318 describing an ion source), is well known to those skilled in the art as well as the effect of the MMC to make the discharge profile more uniform (see for example: J. Hopwood, C. R. Guarnieri, S. J. Whitehair, J. J. Cuomo, "Langmuir probe measurements of a radio frequency induction plasma", J. Vac. Sci. Technol. A11(1), Jan/Feb (1993)152). The MMC assembly always surrounds completely the aperture of the plasma source in order to obtain a uniform plasma density at the exit of the MMC confinement zone where the ion grid optic is secured in the case of ion sources or where lays the substrate in case of plasma sources. That configuration is generally used to treat a static substrate laying immobile under the apparatus.

It is also known to those skilled in the art to combine panels with MMC and electron sources as plasma generator (see for example: K.N. Leung, T.K. Samec, A. Lamm, "Optimization of permanent magnet plasma confinement", Physics Letters, 51A (1975) 490).

The present invention is an improvement of methods and devices for plasma treatment, as disclosed by the prior art, in which the substrate moving through the treatment area is negatively polarized continuously or discontinuously, preferentially with a periodic signal, against one or several facing anodes arranged in this treatment area. For instance, US 6,933,460 describes a plasma treatment method for a substrate crossing the treatment area in which the plasma is confined by magnetic mirrors. Document US 8,835,797 discloses a plasma treatment method for a substrate crossing the treatment area in which the plasma is generated by inductive coupling through several antennas, or Faraday shielding, protecting the inductor from contamination and being the anode of the system.

These plasma treatment methods have in common that the substrate to be treated is moved in a given direction through a vacuum chamber presenting a treatment area in which an electrical discharge is created between one or several electrodes and the substrate, close to the surface of the latter.

Typical applications that are targeted by these plasma treatment methods of negatively polarized substrates with respect to one or several anodes are:
**i)** the elimination of a contamination layer on the substrate, such as a native surface metallic oxide and a superficial carbon contamination layer, so as to promote the adhesion of a coating applied subsequently by a vacuum deposition technique,
**ii)** the heating of the substrate for annealing metal products or for ensuring formation of surface compounds by diffusion or reaction with the substrate when adding reactive substances, such as a gas at a pressure below atmospheric pressure, to the treatment area, and
**iii)** the coating of the substrate by plasma decomposition of reactive gases introduced in the treatment area, i.e. by PECVD.

In general, the above methods can be applied to any substrate that is sufficiently conductive and, therefore, these can be applied to any substrate made from low alloy steel, stainless steel, aluminum, copper and other metals, but also to electrically conductive substrates coated with a thin electrically insulating layer. However, these methods have been developed essentially for industrial applications aimed to the pre-treatment of metal strips before coating by a vacuum deposition method or before PECVD treatment of the metal strips in a high vacuum coating plant.

### Problems of the prior art

Referring to the prior art cited above, if the substrate is kept at ground potential, which is always the case for the continuous treatment of metal products such as strips, sheets, wires or cords, the presence of an anode in a grounded vacuum chamber, the latter is always grounded for safety reasons, is generally subject to a parasitic plasma because the walls of the vacuum vessel constitute electrostatic reflectors for the discharge electrons, i.e. a hollow cathode allowing plasma formation.

The drawback of that is that the walls are subject to ion bombardment which means internal walls erosion and heating as well as important loss of electrical power and the contamination of the product by sputtered material from the vacuum vessel's walls.

The solution that is generally adopted to overcome this drawback is to electrically insulate or shield, with metallic panels secured onto electrical isolators, the internal walls of the vacuum chamber. However, this leads to a higher complexity in the vacuum chamber design because the feedthroughs must also cross the electrically insulated layers or shielding panels and the vacuum pumping ports must be electrically insulated or shielded as well, nevertheless allowing high vacuum pumping speed.

**A second drawback of the prior art** solved by the invention, in particular for the plasma treatment of continuously running products in the plasma treatment area, such as strips or wires for example, is the impossibility of removing the plasma treatment equipment for maintenance without prior removal of the product. That is clearly the case for the device of US 6,933,460 for which the magnets used for the magnetic mirrors surround completely the product and for the apparatus of US 8,835,797 for which the Faraday shielding and the inductor surround also the product during treatment.

**A third drawback of the prior art,** for which the invention brings a solution, is the problem of an uneven treatment along the transversal direction in the treatment area. This is particularly important when the product to be treated extends over a larger distance in a direction transversal to the moving direction than in the latter direction, for example when treating several products simultaneous like parallel wires, a wide strip or plates transported into the treatment area by a conveyor. That is particularly the case when, for reducing the possibility of arcing, a plasma treatment configuration such as described in US 8,835,797 is used. Indeed, in that case, the plasma is generated by inductive coupling with an inductor surrounding the product and protected by a polarized Faraday shielding. It is well known that in such case, where the plasma is generated by volume ionization of the gas by primary electrons energized by inductive coupling and where plasma recombination arises essentially on surfaces, the plasma density is uneven (bell shaped with a maximum at the center of the discharge). This is, in particular, noticed along directions transversal to the running direction of the substrates, such as along the width and the height of the cross section of the treatment area. Hence, plasma treatment of the substrate, that is depending on the local plasma density, is uneven along the direction of the width of the plasma treatment area and presents a maximum in the middle of that area, i.e. at the position of the central axis following the direction travelled by the running product. Accordingly, the dose received by the product after plasma treatment varies along its width transversely to the running direction (or alternatively its height depending on the shapes of the product cross section and treatment area cross section).

The relative dose received by the product typically can vary from a ratio of one at the edges of the product to a ratio of two at its central axis along the direction travelled by the running product. It goes without saying that such a variation of the thickness of a coating across the product width is unacceptable, in particular in steel strip coating or in glass coating, because, in most cases, a maximum variation of thickness of ± 5% is accepted.

Similarly, according to this prior art, in an etching or a heating process applied to a band or strip, the temperature increase in the middle of the product can be twice the temperature increase at its edge, which is unacceptable for mechanical and metallurgical reasons.

**Another drawback of the prior art** is that when the product width is much smaller than the width of the treatment area and the product is moving along that transverse direction when running through the treatment area, the plasma density profile varies in time because that profile is dependent on the temporal position and width of the product in the area. The same is true when the width of the strip changes along its length (frequent in treatment of steel strip). Indeed, the product area in the treatment area constitutes a significant area for charges recombination.

**A further drawback** of the apparatus disclosed by US 8,835,797 is the contamination of the antennas that face directly the product treated when applied for etching or during PECVD. In particular, during low alloy steel etching, the contamination of the antennas, or Faraday shielding, by sputtered iron will decrease the efficiency of the process. As more energy is dissipated in heating the iron contamination layer the energy available for plasma generation decreases accordingly. Even more critical for the sustainability of the process: the contamination of the spacing between nearby antennas can lead to the process shutdown.

### The aim of the invention

The invention aims to overcome the aforementioned drawbacks of the prior art by proposing a method and a device that permit to improve the uniformity of the plasma density along the treatment direction, i.e. along the moving direction of the substrates through the treatment zone. It is also the intention of the invention to extend the length of the treatment area along the treatment direction such that this length becomes larger than the diameter of plasma sources that are positioned in front of the moving substrate, i.e. product, in the treatment zone. Accordingly, a given dose (energy density or coating thickness for example) can be obtained in a longer process area than just the length defined by the plasma source aperture in front of the running substrate or product, whereby substantially the same working parameters are maintained at the plasma source(s).

Further, it is an object of the invention to control the plasma distribution in a direction that is transversal to the treatment direction.

Another object of the invention is to propose a method and equipment configuration for allowing plasma treatment of grounded substrates in a grounded vacuum vessel with unprotected internal walls in presence of an anode or multiple anodes, wherein any possibility of parasitic plasma in the vacuum vessel volume outside of the treatment area is prevented and wherein extremely high vacuum pumping speed of the treatment area is still allowed. This is particularly important when outgassing of the running product, which is to be treated, becomes important. This is, for example, the case for water vapor outgassing during plasma treatment of a product running at high speed, such as a strip or a foil.

Accordingly, the invention aims to provide :
**i)** a method and a device that allow to produce a more uniform plasma density distribution along the treatment direction in the plasma treatment area than what is obtained when using only plasma sources distributed around the running substrate, and
**ii)** a method and a device that allow regulation of the local plasma density variation in the plasma treatment area along a direction transversal to the treatment direction according to a feedback signal following measurement of the plasma density at some specific locations in the treatment area.

The method and the device, according to the invention, can be applied on conductive substrates but also on electrically insulating substrates, such as glass plates and plastic webs, with some particular adaptations to the insulating materials.

### Summary of the invention

In general, the device for plasma-treatment of substrates, according to the invention, concerns a device comprising a vacuum chamber with a plasma confinement enclosure having a treatment zone and presenting a treatment direction along which substrates to be treated are to be moved through the treatment zone. The treatment zone is delimited, in a direction transversal to the treatment direction, by lateral walls of the plasma confinement enclosure, wherein at least one of these lateral walls has an opening for allowing plasma to enter the treatment zone. This opening connects to a plasma source such that plasma generated by the plasma source can enter the treatment zone through this opening.

According to the invention, at least said wall presenting the opening for allowing plasma to enter, presents means for generating a multipolar magnetic cusp field extending along this wall around and adjacent to the opening for forming a plasma diffuser panel.

In an interesting manner, the means for generating said multipolar magnetic cusp field extend along said treatment direction over a distance substantially corresponding to the length of said treatment zone along the treatment direction.

Advantageously, the means for generating said multipolar magnetic cusp field comprise an assembly of permanent magnets or of electromagnets covering the exterior side of said wall with respect to the treatment zone.

According to a preferred embodiment of the device, said confinement enclosure has at least two opposite walls, preferably, extending parallel to said treatment direction on opposite sides of the treatment zone, each of these opposite walls forming a plasma diffuser panel provided with an assembly of permanent magnets or of electromagnets covering the exterior side of said wall with respect to the treatment zone. Each diffuser panel further presenting said opening for allowing plasma to enter the treatment zone, wherein adjacent to said opening are provided said assembly of permanent magnets or of electromagnets.

According to an interesting embodiment, of the device, according to the invention, at least one electron source is provided in the treatment zone for controlling the density of the plasma in the treatment zone.

According to a specific embodiment of the invention, at least one plasma current measurement probe is provided in the treatment zone cooperating with said at least one electron source to control plasma density along a direction transverse to said treatment direction.

According to a further embodiment of the invention, said confinement enclosure has an entry defined by an entry aperture and an exit defined by an exit aperture for said substrates, each of said apertures opening into a corresponding tubular passage extending along said treatment direction on opposite sides of the treatment zone, wherein said tubular passage is electrically isolated such as to be maintained at floating potential.

The invention also relates to a method for plasma treating substrates wherein the substrates are moved along a treatment direction through a treatment zone that is delimited in a direction transversal to said treatment direction by at least one wall forming a diffuser panel presenting an opening. Said plasma is introduced into the treatment zone trough said opening and the plasma is generated by means of a plasma source connecting to said opening. The method is characterized in that a multipolar magnetic cusp field extending along this wall around said opening and adjacent to said opening is generated such that said plasma entering the treatment zone trough said opening is distributed along said wall in the treatment zone.

### Brief Description of Drawings

Further details and advantages of the invention shall be given in the description below of some specific embodiments of the device and method, according to the invention. This description is only given as an example and does not restrict the scope of the protection claimed; the reference numerals used below pertain to the appended figures.
Figure 1 is a schematic partial transparent image in perspective of a preferred embodiment of the device, according to the invention, comprising a confined plasma treatment module for treatment of two opposite faces of a metallic strip.
Figure 2 is a schematic perspective view of the preferred embodiment of the confined plasma treatment module for treatment of the two faces of a metallic strip of Figure 1, without representing the vacuum chamber for improved clarity.
Figure 3 is a perspective view of the assembly of Figure 2 from a different angle.
Figure 4 is a schematic perspective view of a substrate, in particular a product, leaving a confined plasma treatment module that is adapted for the treatment of one face of a running metal strip, according to another embodiment of the invention.
Figure 5 is a schematic perspective view of the inside structure of a subassembly of the confined plasma treatment module adapted for treating a running strip.
Figure 6 is a schematic partial transparent image in perspective of the inside structure of a subassembly of the confined plasma treatment module of Figure 5 showing schematically multipolar magnetic cusps made of alternative rows of opposite polarities 16N and 16S oriented towards the internal wall of the confinement enclosure.
Figure 7 is a schematic cross-section in perspective of the confined plasma treatment module of figures 2 and 3 together with a vacuum chamber.

In the different figures, the same reference figures refer to identical or analogous elements.

### Detailed description of the invention

The invention concerns in general a method and a device for generating a uniform plasma density profile across the transverse direction of a running product to be treated.

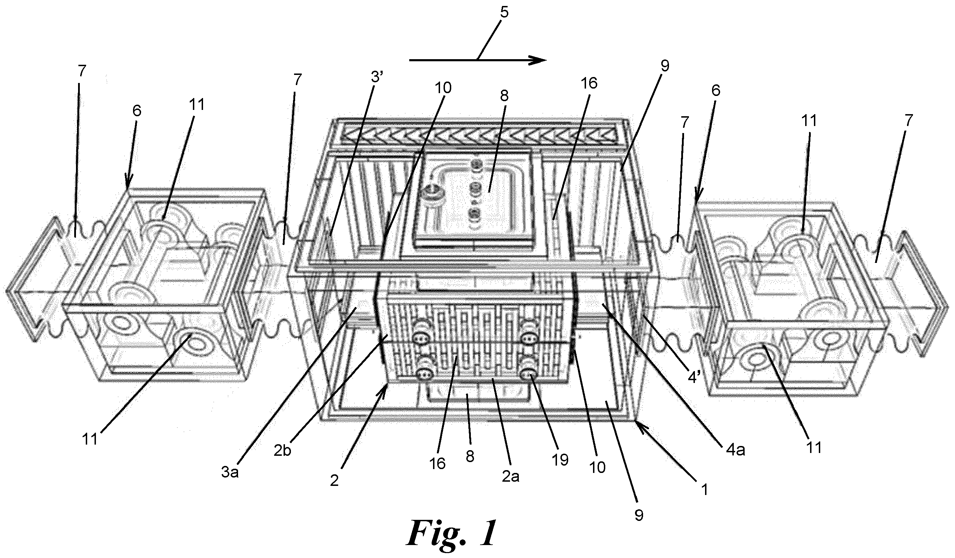

An interesting embodiment of the device, according to the invention, is shown in Figure 1. This device comprises a vacuum chamber 1 containing a confined plasma treatment module 2 for treatment of opposite faces of a continuous substrate, such as a metallic strip, that is moving through the treatment module 2. The metallic strip is not represented in Figure 1 for clarity of the drawing. The confined plasma treatment module 2 presents an entry opening 3 and an exit opening 4 to allow the passage of the metallic strip through the treatment module 2 along a treatment or transport direction 5, i.e. from the entry opening 3 to the exit opening 4.

The inside of the confined plasma treatment module 2 defines a treatment zone that is delimited by walls of the module 2. Accordingly, when plasma treating a product or a substrate, such as a metallic strip, the product enters the treatment zone through the entry opening 3 and, after having traversed the treatment zone, leaves this zone through the exit opening 4 while moving along the treatment or transport direction 5. The treatment zone is also called treatment area or plasma confinement enclosure, confinement area or confinement zone throughout this specification.

Opposite sides of the vacuum chamber 1 have an entry aperture 3' and an exit aperture 4' in front of the respective entry opening 3 or exit opening 4 of the plasma treatment module 2. The vacuum chamber 1 is connected at the entry aperture 3' and the exit aperture 4' to respective roller devices 6 via connecting bellows 7. Accordingly, a roller device 6 is provided upstream and downstream of the vacuum chamber 1. Both roller devices 6 are equipped with rollers 11 for the metallic strip that assure the electrical grounding of the strip and that support the latter.

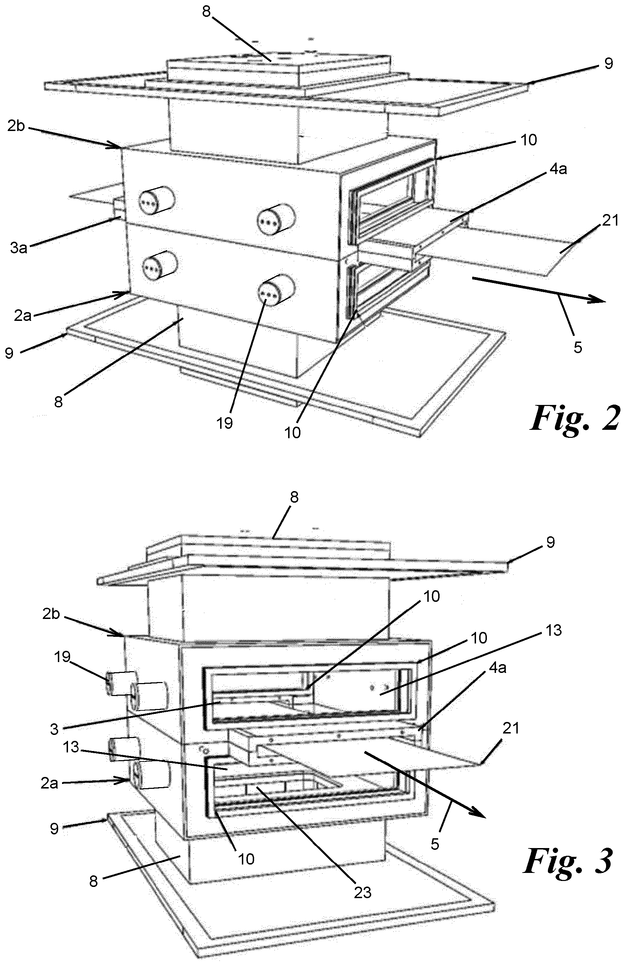

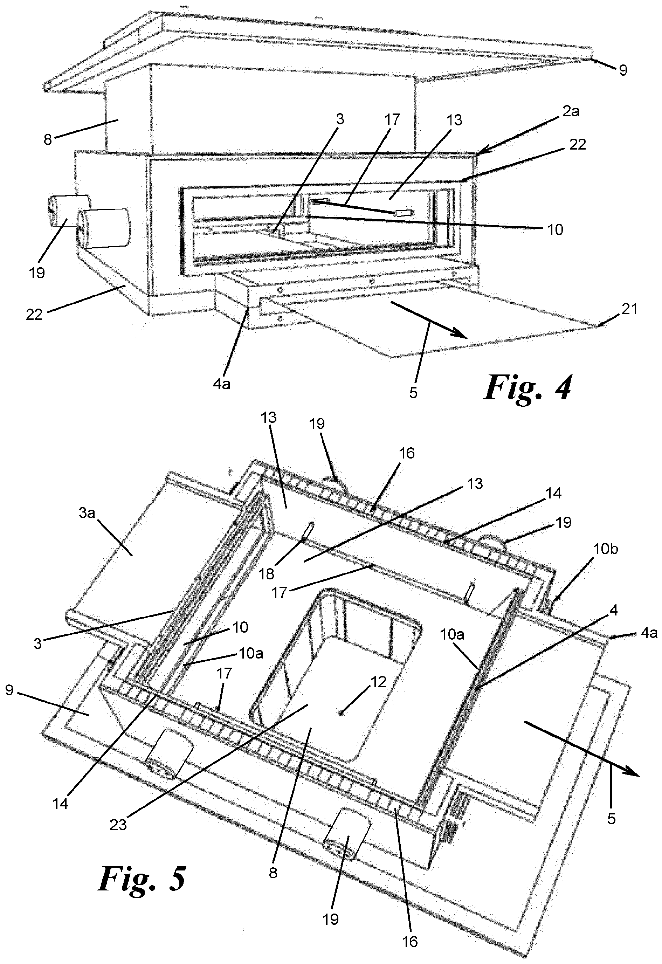

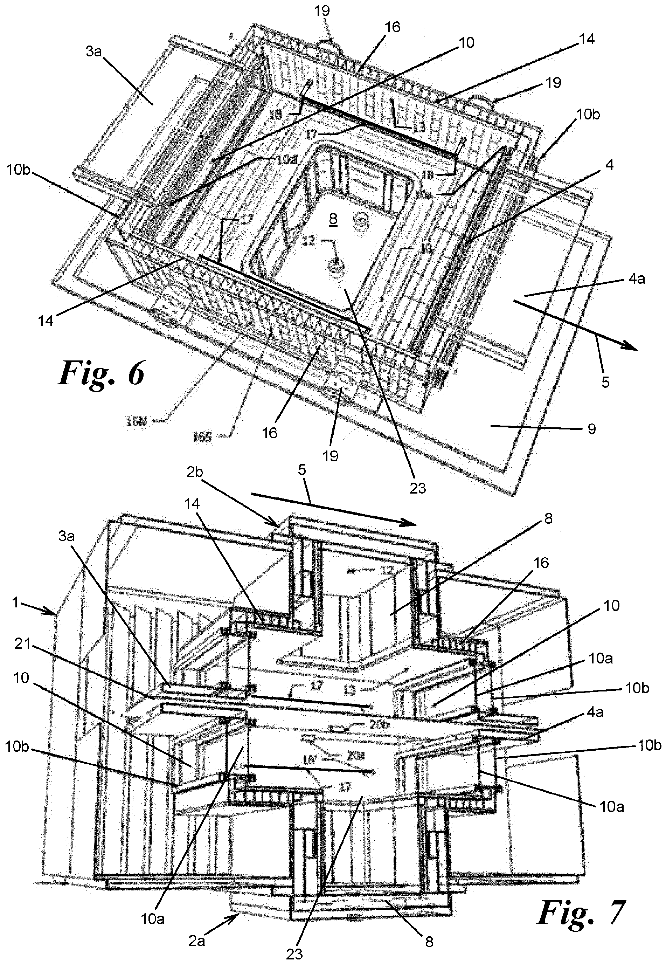

The plasma treatment module 2 of the device represented in Figure 1 is shown in Figures 2, 3 and 7 together with a continuous metallic strip 21. The module 2 comprises two confined plasma treatment module subassemblies 2a and 2b. Figures 5 and 6 represent such a subassembly 2a or 2b.

Each subassembly 2a and 2b presents a corresponding plasma source 8. These plasma sources 8 are each secured to a corresponding cover flange 9. These cover flanges 9 of the subassemblies 2a and 2b constitute opposite walls of the vacuum chamber 1 (see Figure 1).

The inside of the confined plasma treatment module 2 communicates via pumping ports 10 with the interior of vacuum chamber 1. Vacuum pumping of the inside area of the confined plasma treatment module 2 is thus achieved through these ports 10. In the embodiment of the invention represented in the drawings, a pumping port is provided immediately above and beneath each entry opening 3 and exit opening 4. Figure 3 illustrates the plasma treatment module 2 at a different angle such that the pumping port 10 above the entry opening 3 facing the pumping port 10 above the exit opening 4 is visible.

Figure 7 is a vertical cross-section along the transport direction 5 of the confined plasma treatment module 2. This drawing illustrates the presence of a hot filament 17, a lateral ion current probe 20a and a central ion current probe 20b in the treatment zone. These probes 20 a and 20b allow feedback control of electron current and voltage at the hot filament 17 that constitutes a thermionic emitter.

The inside structure of a subassembly 2a or 2b of the confined plasma treatment module 2, adapted for plasma treatment of a running strip, is represented in figures 5 and 6. The confined plasma treatment module 2 of Figures 2, 3 and 7 comprises two of such subassemblies 2a and 2b that are positioned symmetrically with respect to each other such that the entry opening 3 and the exit opening 4 is formed in between the two subassemblies 2a and 2b.

Each of the vacuum pumping ports 10 is formed by an aperture that is covered by an internal metallic mesh or plasma screen 10a and an external metallic mesh or plasma screen 10b. The internal and external metallic mesh or plasma screen 10a and 10b preferably extend parallel to each other, whereby the internal mesh or screen 10a extends at the side of the interior of the concerned subassembly 2a or 2b and the external mesh or screen 10b is directed to the exterior side of the subassembly 2a or 2b. The distance between the internal and external metallic mesh or plasma screen 10a and 10b is, preferably, larger than 5 mm. The pumping ports 10 are preferably, but not necessarily, situated close to or adjacent to the entry and exit openings 3 and 4 of the plasma confinement enclosure 15.

The subassemblies 2a and 2b have metallic internal walls 13 that are polarized against the substrate or product 21, in particular positively, such that the walls 13 form an anode with respect to the product 21. The walls 13 are electrically connected to the internal metallic mesh or plasma screen 10a of ports 10, whereas the external metallic mesh or plasma screens 10b are left at floating potential or are connected to the potential of the vacuum chamber 1, which is generally grounded.

The hot filament thermionic emitter 17 extends in front of each of the internal walls 13 and parallel to these walls 13. Each emitter 17 is supported by two electrical feedthroughs 18 that extend through the walls 13 and that are connected to respective connectors 19 fixed to the outside of the plasma treatment module 2. In the embodiment of the invention represented in the drawings, the emitters 17 are parallel to the transport direction 5 and extend at the lateral sides of the treatment zone close to the walls 13. However, for a person skilled in the art, it is clear that it is not required that the hot filament emitters 17 extend parallel to the transport direction 5.

The presence of hot filament thermionic emitters 17 allows to regulate the plasma density profile in a direction that is substantially transverse to the treatment direction 5. This regulation of the plasma density profile is realised by injecting electrons in the plasma treatment area at proximity of the multipolar magnetic cusps (MMC) at controlled current and controlled voltage following a feedback signal corresponding to plasma current measurements by probes 20a and 20b. Such probes 20a and 20b are secured at some specific locations in the plasma treatment area and are preferably formed by ion current probes.

Some advantages of combining the electron emitters 17 at proximity of the multipolar magnetic cusps (MMC) with the probes 20a and 20b are:
**i)** a more uniform plasma density distribution can be realised than when using only MMC panels with plasma source(s),
**ii)** the possibility of controlling the ionization in a direction transversal to the transport direction by these independent electron sources 17 in response to a feedback signal, wherein this feedback signal corresponds to the actual plasma density profile along a direction transversal to the transport direction. In this way, it is possible to compensate in real time plasma density variations that are due to product displacements or a change of the width of a product running through the treatment zone.

The internal walls 13, onto which condenses possibly process residues, are electrically insulated from the rest of the equipment by electrically insulating sheets 14. These sheets 14 extend along the external side of the walls 13.

In order to create a magnetic field inside the confined plasma treatment module 2 and adjacent to the walls 13, the latter are covered by multipolar magnetic cusps generated by magnets with alternating polarity directed towards the concerned wall 13. Said insulating sheets 14 are, preferably, provided between the walls 13 and the corresponding magnets. The side of the magnets, opposite to the walls 13, is supported by plates of ferromagnetic yoke or a magnetic induction shield. The walls 13 are made of non-magnetic material such as, for example, copper or aluminum, and are, preferably, water-cooled.

Figure 6 illustrates the inside structure of a subassembly 2a or 2b of the plasma treatment module 2, wherein the multipolar magnetic cusps arrangement 16 comprises alternative rows of magnets with poles of opposite polarities 16N and 16S being oriented towards the internal wall 13.

Process gas is introduced into the confined plasma treatment module 2 through the plasma source 8 via a gas nozzle 12 provided to this effect.

Figure 4 represents an embodiment of a confined plasma treatment module 2, according to the invention, that is adapted for the treatment of one face of a substrate or product formed by metal strip 21 that is moving through the treatment zone according to transport direction 5. Accordingly, the module 2 only comprises a single subassembly 2a that is mounted to a closing panel 22 instead of to a second subassembly 2b. The treatment zone for the strip 21 is thus delimited by this panel 22 and the walls 13 of the single subassembly 2a. The presence of the panel 22, without a multipolar magnetic cusps arrangement, prevents formation of plasma between the panel 22 and the strip 21.

Thus, in general, the invention concerns a plasma treatment module 2 comprising one or more plasma sources combined with at least a plasma diffuser panel. Such a plasma diffuser panel presents a temperature controlled metal shield that faces the treatment zone and thus corresponds to said internal wall 13 of the module 2. The diffuser panel, and thus the wall 13, extends along said transport direction 5 of the products to be treated. Preferably, the panel is parallel to this transport direction 5, however, this is not required. It is clear that the panel must not cross the path of the product 21 moving through the treatment zone. Accordingly, the panel, or the corresponding wall 13, delimits the treatment zone along a direction transversal to transport direction 5.

The plasma diffuser panel is covered by a network of elements generating magnetic induction fields such that the surface of said metal shield of the panel, that is facing the treatment zone, is covered with multipolar magnetic cusps (MMC). The metal shield facing the plasma treatment area, i.e. wall 13, is electrically insulated, at the opposite side of the treatment area, from said network of elements generating magnetic induction fields. This electrical insulation is, for example, realised by said insulating sheet 14.

The plasma sources 8 connect to an aperture 23 through which the plasma generated by the concerned source 8 enters the treatment zone. According to the invention, said diffuser panel, in particular said multipolar magnetic cusps, extends adjacent to the aperture 23 of the plasma source 8. Preferably, the multipolar magnetic cusps extend around this aperture 23 such that this aperture 23 forms an opening in the concerned diffuser panel.

According to a preferred embodiment of the device of the invention, said network of elements comprises an assembly of permanent magnets. Accordingly, the multipolar magnetic cusps are generated by this assembly of permanent magnets.

Preferably, the treatment area is closed around the conveying path of the product 21 by said walls 13 such that the plasma treatment area is tubular. Accordingly, the embodiment of the device represented in figure 7 presents a tubular treatment area that is delimited in a direction transversal to the transport direction 5 by said walls 13 extending substantially parallel to the transport direction 5.

In the embodiment represented in figure 7, the walls 13, that are extending in front of the surface of the product strip 21, present the aperture 23 through which the plasma, generated by the concerned plasma source 8, enters the treatment zone.

Further, in this embodiment of Figure 7, the walls 13 extending along the lateral edge of the product strip and parallel to the transport direction 5 are also covered with said magnetic multipolar cusps (MMC) and thus constitute diffuser panels, however without an aperture for connecting to a plasma source.

These walls 13 are thus enclosing the tubular treatment area and are provided with said magnetic multipolar cusps (MMC) over substantially their entire surface as explained above.

At the entry opening 3 and at the exit opening 4 of the treatment zone, i.e. the plasma confinement enclosure 15, the extremities of the walls 13 connect to transverse walls extending transversal to the transport direction 5 of the product 21. Accordingly, a confined plasma enclosure 15, or plasma diffuser, is formed within the plasma treatment module 2 having only an aperture towards the vacuum chamber at said entry and at exit openings 3 and 4 wherein the edge of this aperture extends at a small distance from surface of the moving product 21.

When the device is adapted for treating only one side of a product 21, such as a represented in figure 4, the wall close to the surface of the product 21 and forming closing panel 22 is not provided with MMC such as to prevent or significantly reduce the plasma density between the closing panel 22 and the side of the product 21 that is directed to this panel 22 and that is opposite to the treated side of the product 21.

A preferred embodiment of the device, according to the invention, is represented in figures 1, 2, 3 and 7. In this embodiment the device is obtained by juxtaposition of two subassemblies 2a and 2b as already explained above. It is of course also possible to realize a device according to still another embodiment of the invention wherein more than two subassemblies are connected to each other.

The entry opening 3 and the exit opening 4 connect to entry and exit tubular manifolds, in particular tubular passages 3a and 4a, enhancing plasma decay from the treatment area to the vacuum chamber volume. The internal walls of these tubular passages 3a and 4a are extending at a small distance from the product 21 that is moving through the treatment area along the transport direction 5. Accordingly, any electrical conduction by plasma between the treatment area and the volume of the vacuum chamber is prevented to avoid the formation of parasitic plasma in the volume of the vacuum chamber outside of the treatment area. The tubular passages 3a and 4, preferably, extend in the vacuum chamber 1 and outside the plasma confinement enclosure 15.

Preferably, said tubular passages 3a and 4a, or manifolds, are made of electrical insulating materials, or of a combination of metals and electrical insulating elements, such as to be electrically isolated from any electrode or from the ground. Accordingly, these tubular passages 3a and 4a are at floating potential.

According to an interesting embodiment of the invention, said tubular passages 3a and 4a present additional elements, also called closing means, for increasing the area of the passages 3a and 4a, in particular of the internal walls thereof, for enhancing plasma recombination and for decreasing the open area between the treatment area and the vacuum chamber volume. In general, such additional elements, also called closing means, are provided for decreasing the distance transversal to the transport direction 5 between the tubular passage, i.e the internal walls thereof, and the products moving through the passage. These elements are, for example, filling at least partially the passages 3a and 4a, and can possibly be in contact with the running products 21. Such elements, for example, comprise brushes, sliders, rolls, mobile shutters, etc.

According to an advantageous embodiment of the invention, said plasma diffuser panels are polarized continuously or discontinuously, in particular positively, against the substrate. Thus, the plasma diffuser panels, forming said walls 13, are on average positively polarised with respect to the substrate, for example.

As already indicated above, in an interesting way, the plasma diffuser panels, forming walls 13, are electrically connected to the internal mesh or plasma screen 10a of the pumping ports 10.

According to an interesting alternative embodiment of the device, according to the invention, said aperture 23 of the plasma source or sources 8 is covered by a set of parallel grids forming a so-called ion optic of a large beam ion source. In this way an ion source is obtained.

In an interesting way, such an ion source is combined with external electron sources directed towards the ion beam flowing between the source ion optic and the running substrate 21.

The one or more plasma sources 8 of the device, according the invention, are, in general, preferably inductively coupled.

Further, the plasma sources 8 may be protected by Faraday shielding. Such a Faraday shielding is preferably not directly facing to the plasma source aperture 23, i.e. the surface of the running product 21, in order to minimize Faraday shielding's contamination by condensation of process residues.

In general, the device, according to the invention is working at a gas pressure below 5.10⁻³ mbar. Thus, the gas pressure in the vacuum chamber 1, and consequently in the plasma confinement enclosure 15, is preferably maintained at a pressure below 5.10⁻³ mbar.

Thus, according to the invention in general, one or several plasma sources 8 for generating a plasma are combined with a magnetic multipolar plasma confinement system. This confinement system comprises multipolar magnetic cusps (MMC) that are provided along walls 13 that are extending substantially parallel to the transport direction 5 of the product 21 and wherein closing panels 22 extending substantially perpendicular to that direction do not present such MMC.

Such a configuration permits to improve the uniformity of the plasma along a direction transversal to the transport direction 5. The panels provided with MMC forming the walls 13, that extend along the transport direction 5, ensure that the plasma is extended along the transport direction 5, thereby improving the uniformity of the plasma density in a direction transverse to this transport direction 5. Thus, extending the areas covered with MMC along the transport direction 5 increases ionisation along this direction and reduces plasma diffusion in transverse direction, hence uniformity of the plasma density in this transverse direction is improved.

Another significant advantage of this configuration is that it permits to extend the length of the treatment area with respect to the length of the apertures 23 communicating with the plasma sources 8. Accordingly, a given dose (energy density or coating thickness for example) can be applied to the product 21 in a longer process area than just the length defined by the aperture 23 of the plasma source 8 in front of the running product while keeping substantially the same working parameters at the plasma source 8.

The advantage is a result from the fact that a distributed plasma in an extended area reduces the average plasma density such that the possibility of arcing is reduced. Further, this increases the surface of the equipment, in particular the walls, recovering the possible contamination generated by the process, for example, sputtered material from the substrate surface during a sputter etch process or deposit of a contamination layer during a PECVD process. This increase in length of the treatment area allows, for given conditions at the source(s) 8, more working time to get a given thickness of contamination onto the walls, i.e. the MMC panels, and the plasma source(s) 8 facing the running product. For example, if the contamination layer is formed by iron from plasma etching of a running low alloy steel product, that contamination layer shunt the magnetic induction field at the MMC increasingly with its thickness and decreases the efficiency of the MMC panels. There is a significant interest to distribute that contamination layer onto surfaces of equipment as widely as possible in order to increase the working time of the device which is generally linked to a maximum thickness allowable for a given contamination layer. The working time is the maximum time during which the device can be operated without interruption for removing contamination layers from the walls.

The absence of any MMC assembly on the closing panels 22 crossing the path of the product imparts two supplementary significant advantages:
**i)** it allows to decay totally the plasma density towards the volume of the vacuum chamber 1, possibly by addition of electrically insulating manifolds, i.e. tubular passages 3a and 4a, at the entry and exit openings 3 and 4 or by providing simple transversal closing panels,
**ii)** it enables to provide pumping ports 10 with meshes 10a and 10b that prevent the plasma to extend in the volume of the vacuum chamber 1 while allowing high vacuum pumping speed towards the vacuum housing chamber 1. That is of special importance to avoid any parasitic plasma in the volume of the vacuum chamber 1 when the substrate 21 is electrically conducting and at the same potential as the internal walls of the vacuum chamber 1, in particular at ground potential, while an anode is present in the treatment zone.

### Examples of different embodiments of the invention (non-limitative) : Operating conditions and particular configurations of the invention for use in plasma treatment of steel strip

### 1. One step treatment of both faces of a strip

Prior to coating a steel strip by physical vapor deposition (PVD) or plasma enhanced chemical vapor deposition (PECVD), in order to enhance the adhesion of the coating, the steel strip surface has to be decontaminated from any contaminating adsorption layers such as water vapor, carbonaceous contaminants but also, in most cases, the native superficial oxide layer has to be removed. That is achieved by generating a plasma of argon maintained at a pressure of typically 10⁻³ mbar in the confined plasma treatment module 2 installed in the vacuum chamber 1 as shown in Figure 1. The argon pressure is maintained by balancing the inlet of argon in the module 2 the via the gas nozzle 12 at each plasma source 8 and the outlet of argon by vacuum pumps not shown in Figure 1. The gas is essentially pumped out of the confined plasma treatment module through the pumping ports 10 as shown for instance in Figure 2. The pumping ports are designed to maximize the pumping speed and to prevent totally the plasma diffusion towards the outside of the plasma confinement enclosure 15. To achieve that, as well known by those skilled in the art, a large pumping window 10 must be used that is screened with a fine mesh 10a whose typical spacing between adjacent wires is lower than the plasma sheath thickness forming at that interface plasma/mesh. A further improvement of that design aiming to limit the loss of ions, is to place a second mesh 10b at a large distance from the first mesh 10a at floating potential. These large pumping ports 10 are necessary when a large amount of water outgassing from the strip surface must be pumped out the confined plasma enclosure 15. In the preferred embodiment shown in Figure 1, the two subassemblies 2a and 2b of the confined plasma treatment module 2 are connected to the vacuum chamber 1 via the flanges 9 as shown in Figure 2. Hence the equipment is externally maintained at the potential of the vacuum chamber walls, i.e. grounded in this case. The strip 21 crosses the confined plasma treatment module 2 via the entry manifold 3a and the exit manifold 4a. The role of those manifolds, or tubular passages, build in dielectric material, is to achieve the total recombination of the plasma inside of these manifolds. As stated above there is no MMC crossing the entry and exit apertures 3 and 4 of the confined plasma treatment area 15 and, of course, no magnetic field is present at the surface of the manifolds 3a and 4a that could trap electrons and reduce the plasma recombination at their walls. These manifolds 3a and 4a, as well as the two facing meshes 10a and 10b in the pumping ports 10, create an infinite electric resistance between the plasma and the walls of the vacuum chamber 1, i.e. no electron emitted in the vacuum chamber 1 outside of the plasma confinement enclosure 15 is able to return by electrical conduction to the plasma inside of the confined plasma treatment module 2. Hence any risk of gas breakdown outside of the confined plasma treatment area 15 is prevented. The lateral walls 13 of the confined plasma treatment module 2 are covered by multipolar magnetic assemblies MMC 16 formed by racetracks or closed loops of magnets of alternate polarities (see Figures 1 and 6). The direction of polarization of these magnets is parallel to the perpendicular to the plane on which they are supported. The magnets are backed by an iron yoke or plate at ground potential shielding the magnetic field at the external surface of the equipment. At the opposite extremities to the iron yoke, the magnets are covered by an electrically insulating material 14 secured onto metallic internal walls 13. These walls 13 are non-magnetic, such as copper or aluminum, water-cooled for allowing the magnetic field to develop at the surface inside of the confined plasma treatment module 2. These panels or walls 13 are connected to the anode of an electrical generator via a connector not shown, the negative polarity of that generator, grounded, being connected to the strip 21 via the contacting rollers 11 in the roller devices 6. At the lateral walls 13, at both sides of the strip 21 for the two subassemblies 2a and 2b, in the preferred embodiment, there are four electron emitters formed by hot filaments 17 that assure a complementary plasma ionization at the vicinity of the lateral MMC panels, ionization independent of that of the two plasma sources, one for each subassembly, that couple the main part of the energy to the plasma by coupling inductively to plasma electrons through Faraday shielding. Those, skilled in the art know how to handle the source processing parameters. Because of the presence of the anode, the plasma potential is raised to a value close to that of the anode, allowing ions generated in the plasma to be accelerated towards the strip surface in the sheath formed at the plasma/strip interface. This ion bombardment induces sputtering of material from the strip surface, essentially iron, that condenses onto facing metallic internal walls 13. It is noticeable that the magnetic field generated by the MMC at the surface of the metallic internal walls 13 is progressively shunted by the iron contamination layer. That explains the interest to extend the distance of the plasma confinement enclosure 15 compared to the distance travelled by the strip under the source 8. Indeed, increasing that distance allows the distribution of the plasma in a larger volume, hence decreases the plasma density and, as a corollary, the local contamination of the metallic internal walls 13 and the arcing probability during etching of the strip for reasons well known by those skilled in the art. Figure 5 clearly shows the interest of a fast decay of the plasma density from the middle of the plasma source 8 towards the pumping port 10 and manifolds 3a and 4a to minimize the thermal load by plasma recombination onto these parts of the equipment, and also to reduce the length of the manifolds 3a and 4a. For that reason, there is no magnetic confinement at and after the exit and entry of the confined plasma treatment zone defined by the two lateral MMC panels. Still considering Figure 5, showing the detail of the internal equipment of the module for a subassembly 2a or 2b, the source 8 generates most of the plasma. The plasma density profile in the plasma source and at the exit of the plasma source is bell shaped, i.e. presents a maximum of plasma density in the middle of the source. Outside of the plasma source, the plasma expands laterally and reaches the MMC panels where, for the principal mechanism responsible of a more uniform plasma density across the strip width, the primary electrons from the plasma are trapped by the MMC magnetic field lines located in the vicinity of the panels which lengthens the electron trajectory, hence the ionization probability close to the panel, steepening the plasma density variation between that local ionization area in the MMC magnetic field trap and the panel, hence smoothing the plasma density variation in the opposite direction towards the axis of the strip 21. The hot filament 17 allows the emission of a controlled electron current at a negative controlled potential referring to the potential of the anode. These high kinetic energy electrons, or so-called primary electrons, are immediately trapped by the magnetic field lines of the MMC because these are emitted directly in the magnetic field and allow a significant complementary ionization of the gas at the edges of the strip 21 depending on their kinetic energy. At fixed electronic current, the ionization rate of the gas is easily controlled by the kinetic energy of the electrons. If that energy is below the value of the first ionization potential for argon there is no complementary ionization. The ionization probability of argon is maximum for an electron kinetic energy of about 50eV. Referring to Figure 7, that is a cross-sectional view of the equipment described above, one lateral ion current probe 20a and one central ion current probe 20b are secured in the subassembly 2a, close to the strip 21 and with the probes areas facing towards the plasma source 8. These probes are polarized slightly negatively against the plasma potential to measure the local ion saturation current. The current difference measured by the probes 20a and 20b indicates the same difference of values onto the adjacent surface of the strip. In order to equilibrate these values of ion current at probes 20a and 20b, a feedback mechanism regulates the voltage applied to the hot filament 17. Generally, without polarization of the hot filament 17, the probe 20a measures a lower current than the probe 20b. Then, in order to cancel the measured ion current difference, it is necessary to increase the ionization of argon at the side of the strip 21 by increasing progressively the voltage applied to the hot filament 17. Hence, these electrons emitters, thanks to a feedback from the probes20a and 20b, allow to control in real time the plasma density profile in the transversal direction, i.e. along the strip width, according to various unpredictable perturbations such as lateral displacements of the strip or strip width variations. It is noticeable that at 50eV of max kinetic energy for ions that necessarily bombard the hot filament (in tungsten), the sputtering rate of the filament is negligible. Applying a positive potential of several hundred of volts onto the metallic internal walls 13 against the grounded strip will favour the sputtering of the strip surface. Because sputtering is a ballistic process, under a pressure of 10⁻³ mbar in argon for the geometries of interest, the sputtered iron will condense mostly onto the surface facing the strip, i.e. less onto the antennas of the Faraday shielding of inductive plasma sources 8, less onto the lateral MMC panels, less onto the internal meshes of the pumping ports 10 whose surfaces are oriented with their generators parallel to the normal to the faces of the strip. That geometrical embodiment, minimizing the contamination onto critical elements of the equipment, increases its time of use before maintenance.

The equipment just described above is specially adapted to etching but also to PECVD when the pressure is lower than about 5. 10⁻³ mbar. That limit of pressure is actually determined by the confinement of electrons by the magnetic field at the MMC panels. At fixed power coupled to the plasma, a decrease in pressure improves the confinement of the electrons and decreases the rate of the process. A pressure of about 10⁻³ mbar is shown to be the optimum pressure for sufficient trapping of electrons by the magnetic field at the MMC panels in order to achieve enough ionization in the trapping zone, hence generate a uniform transversal plasma treatment, and also assure a maximum rate for that process. In a PECVD process where the goal is to produce a thin coating onto the substrate surface a mixture of reactive gases, instead of argon, is introduced in the confinement plasma treatment module through the gas nozzle 12. Examples of typical coatings that can be produced using the confined plasma treatment module, according to the invention, are:
- Amorphous hydrogenated Silicon - a-Si:H
- Micro crystalline Silicon - µc-Si
- Silicon Nitride - Si3N4
- Silicon Oxide SiO₂
- Zinc Oxide - (TCO)
- Titanium Oxide-TiO₂
- Aluminum Oxide-Al₂O₃
Reactive etching can be used, for instance etching with a mixture of argon and hydrogen for low alloy steel strip etching prior to deposition. Prior art document EP 0780485 shows that the etching rate of low alloy steel can be increased at a fixed power by mixing the argon with hydrogen in a given proportion.

### 2. Treatment limited to one face of the running strip

In order to treat only one face of the strip, only one subassembly equipped with one plasma source and MMC panels is needed, the plasma source facing the face of the strip to be treated as shown in Figure 4. Everything that has been described concerning the working principle for two joining subassemblies in the preceding section for treatment in one step the two faces of the strip, is still valid for one subassembly facing one face of the strip.

In order to prevent any parasitic plasma in the volume of the vacuum chamber, outside of the confined plasma treatment area, the subassembly 2b is closed by a closing panel 22. This closing panel 22 is made by the assembly of an internal metallic plate electrically connected to the potential of the metallic internal walls 13, electrically insulated from the electrical potential of the external shielding also metallic. The closing panel 22 is also provided with one half of the entry manifold 3a (not shown) and one half of the exit manifold 4a joining with the corresponding half manifolds secured onto the subassembly 2b. Because of the absence of any plasma source and magnetic confinement in the closing panel 22 and also because of the short distance between the internal surface of the closing panel 22 and the face of the strip 21 opposite to the treatment side, no plasma forms between the strip and the closing panel 22, hence this face of the strip 21 is not plasma treated. The subassembly 2b must generally be closed by a closing panel 22 when the product 21 is polarized (pulsed or DC) negatively against the walls 13.

### 3. Treatment of one face of a running glass panel

Without polarization of the metallic internal walls 13, there is no risk of formation of parasitic plasma outside of the confined plasma treatment area. That is typically the case of PECVD onto electrically non-conducting substrates such as running glass plates. In that case the treatment is achieved by a simple subassembly such as shown in Figures 5 and 6, hovering a short distance (< 10 mm) above the running surface to be treated. The product is running from the entry to the exit of the confined plasma area in a direction substantially parallel to the MMC panels.

### 4. Treatment of a foil or web supported by a roll

Shaping the subassembly, for instance making it curved from entry to exit of the plasma confinement area, such as to hover at short distance above a bended foil supported onto a roll, allows to treat foil or web. In the case of a plastic web it could be a coating by PECVD, an activation treatment in an oxygen plasma etc.

### 5. Large ion source for treatment of running products

Closing the subassembly, such as shown in Figures 5 and 6, by a set of ion grids forming a so-called ion optic, using classical arrangements with 1, 2 or 3 grids, well known by those skilled in the art, the ion optic being parallel to the surface of the running product, transforms the subassembly into a large ion source. Ions are extracted by the ion optic at given energy fixed by the electrical potential set onto the metallic internal walls 13. The ions are eventually neutralized by an external source of electrons, for instance a hollow cathode.

### Examples of applications

### Example 1: Steel strip etching prior to coating by physical vapor deposition

Prior to physical vapor deposition, in order to promote good adhesion of the coating, it is mandatory to outgas the adsorbed water vapor and sputter-etch the carbonaceous contamination and the oxide layer always present at the surface of the low alloy steel strip. That can be achieved advantageously using a confined plasma etching module as shown in Figures 1 to 3 allowing the etching of two faces of strip in one step. That module composed of two joining subassemblies fully equipped as described in above section 1 ('One step treatment of both faces of a strip'). Each half module is composed of one plasma diffuser whose dimensions are 3330 mm in length (running strip direction), 2000 mm in width (corresponding to the direction of the strip width) and 150 mm of depth (direction perpendicular to the face of the strip). Each half module is fed by an inductively coupled plasma, the inductor being protected from iron contamination by a Faraday shielding. The plasma source aperture to the half plasma diffuser, facing the running strip, is 1800 mm long (in the direction of the strip width) and 200 mm wide in the direction of the running strip. The steel strip is grounded via the grounding rollers 11 in the two roller blocks 6 surrounding the confined plasma treatment module. The module is equipped with an entry manifold 3a and an exit manifold 4a. It is also equipped of four pumping ports of large dimension (1800x100 mm) allowing high vacuum pumping speed of the inside of the confined plasma treatment area. Four independently controlled electron emitters, i.e. tungsten hot filaments 17, emit electrons at controlled voltage to compensate the plasma density variations due to variation of strip width as well as transversal displacements. Each filament voltage is controlled by an independent circuit comparing the ion current measured by a probe close to the filament 17 facing the plasma source to the ion current measured by a probe facing also the plasma source but secured at the central axis of the running direction. When a difference of current is measured, i.e. when the current measured by the probe secured close the filament is lower than the current measured by the probe secured at the equipment central axis, the voltage polarization of the filament is increased until current equality is achieved and inversely. The great advantage of this configuration, beside the advantage of the regulation of the ion current density across the strip width, is that with this specific sizing, the equipment allows to spread the plasma in a much longer treatment area than the plasma source aperture width, i.e. allows to distribute the sputter-etched iron onto a much larger area than the internal area of the plasma source. Hence, the system can work 14 days before maintenance for removal of the contamination layer condensed onto the internal surface 13 of the plasma diffuser. In order to etch the strip, three units of confined plasma etching module are needed. The typical configuration of the system is the following:
- Strip width up to 1800 mm
- Line speed up to 5 m/s
- Working time before maintenance: 14 days
- Two faces treatment in one step with three etching modules in series separated by roller blocks in vertical configuration
- Installed RF power per etching module: 2 x 30 kW
- Installed DC power per etching module: 180 kW
- Total installed power for 3 etching modules: 720 kW

### Example 2: Steel strip coating by plasma enhanced chemical vapor deposition (PECVD)

A strip can be coated by PECVD, either directly after etching, or after coating realized by PVD, using the same configuration of confined plasma treatment module as the one used for etching in example 1. For example, a passivating layer of 2.5 nm of SiO₂ can be deposited onto both faces of the strip using one confined plasma treatment module of the same configuration as the one used for etching in example 1. Hot ion current probes 20a and 20b are used to prevent their contamination by SiO₂. The typical configuration of the system is the following:
- Strip width up to 1800 mm
- Line speed up to 5 m/s
- Working time before maintenance: 14 days
- Two faces treatment in one step with 1 confined plasma treatment module surrounded by two roller blocks with grounding rolls in vertical configuration
- Installed RF power: 2 x 30 kW
- Installed pulsed DC power for biasing: 60 kW
- Process gases: HDMSO (Hexamethyldisiloxane) and oxygen
- Working pressure: < 5^{∗}10⁻³ mbar
- Total installed power: 120 kW

### Example 3: Pre-treatment of glass substrates by Ar/O₂ ions beams prior to deposit of Al doped zinc oxide thin film

Textured TCO (transparent conducting oxide) surfaces are required in silicon thin film solar cells to improve light trapping efficiency. Ion beam treatment of the glass substrate prior to deposit ZnO:AI films by magnetron sputtering allows to achieve as-grown rough ZnO:AI films and suppress the need for ZnO:AI film etching in HCI after sputtering. Hence, that process offers the significant advantage to avoid to break vacuum between TCO and silicon deposition provided that appropriate interconnection process is available. The pretreatment of the glass surface is achieved using one subassembly of the confined plasma treatment module arranged in ion source as described in above section 5 ('Large ion source for treatment of running products'). The ion source is equipped with a three grids ion optic closing totally the open aperture of the subassembly module, opposite to the aperture of the plasma source. The internal grid is at the same potential as the anode surface, the external, or accelerating, grid facing the running glass substrate is at ground potential. Both sides of the subassembly, at the extremities of the grounded shield of the two lateral MMC panels, are secured two hollow cathodes emitting electrons towards the transversal direction in the 50 mm of free space between the accelerating grid and the surface of the running substrate. These electrons neutralize the positive electric charge of the ion beam directed towards the glass substrate surface. The typical configuration of the system is the following:
- Glass substrate: 1250x1100 mm²
- Length of the confined plasma area (direction of transport of the product): 500 mm
- Width of the confined plasma area (distance between facing lateral MMC panels, transversally to the conveying direction): 1300 mm
- Ion optic aperture area: 1300x500 mm²
- RF installed power: 12 kW
- DC installed power: 10 kW
- Process gas: Ar (50%), O₂ (50%)
- Working pressure: 10⁻³ mbar
- Ion energy range: 500-1000 eV
- Maximum neutralization current: 13 A

The invention is of course not limited to the geometries of the device described hereabove. The device of the invention may present any possible geometry. For example, the plasma diffuser panels are not to be limited to one as represented in figures 5 and 6 or two subassemblies such as 2a and 2b such as represented in Figures 2 and 3. It is, for example, possible to assemble four subassemblies, one subassembly for each of the four sides of the treatment area. Each subassembly could be provided with no, one or more plasma sources. The subassembly is not necessarily with one side at atmospheric pressure, i.e. crossing one wall of the vacuum chamber 1, and the other side in vacuum, it could be completely mounted inside of the vacuum chamber 1.

The shape of the entry and exit openings 3 and 4, or of the tubular passages 3a and 4a, can be different from those represented on the figures, depending on the shape of the product cross-section or, for example, of the number of products treated in parallel. Accordingly, it is possible to provide tubular passages for wires, cords and long products. It is also possible to provide several passages in parallel, one for each product treated in parallel. The plasma diffuser MMC panels have just to be substantially parallel but do not need to be exactly parallel to the transport direction of the product, meaning that these panels may not cross the path of the product, but they may have different shapes than that of a surface parallel to the transport direction. These panels can, for example, simply make an angle with that direction, be curved, or "V shaped" or present a combination of these shapes. The geometry of the plasma source could be different etc.

The invention is not limited to MMC built with permanent magnets but the MMC can also be built by a magnetic field generated by passing a current in a structure of wires or so-called picket fence structure. The electron sources are not limited to hot filaments (HF) thermionic emitters but could be as well constituted by cold thermionic emitters, hollow cathodes or plasma bridges.

## Claims

1. Device for plasma-treatment of substrates comprising a vacuum chamber (1) with a confinement enclosure (15) having a treatment zone and presenting a transport direction (5) along which substrates (21) to be treated are to be moved through the treatment zone, said treatment zone being delimited in a direction transversal to said transport direction (5) by lateral walls (13) of the confinement enclosure (15), at least one of said lateral walls (13) having an aperture (23) for allowing plasma to enter the treatment zone, wherein said aperture (23) connects to a plasma source (8) external to said treatment zone such that plasma generated by the plasma source (8) can enter the treatment zone through said aperture (23), **characterised in that** said at least one wall (13) having said aperture (23) presents means for generating a multipolar magnetic cusp field (16) extending along this wall (13), wherein this multipolar magnetic cusp field extends at least partially around said aperture (23) and adjacent to this aperture (23) for forming a plasma diffuser panel.

2. Device according to claim 1, wherein said multipolar magnetic cusp field extends adjacent to said aperture (23) around the full circumference of the aperture (23).

3. Device according to claim 1 or 2, wherein said means for generating said multipolar magnetic cusp field extend along said transport direction (5) over a distance corresponding to the length of said treatment zone along the transport direction (5).

4. Device according to any of claims 1 to 3, wherein said lateral walls (13) of the confinement enclosure (15) extend substantially parallel to said transport direction (5).

5. Device according to any of claims 1 to 4, wherein said walls (13) of the confinement enclosure(15) are polarised at least on average positively with respect to the substrate (21).

6. Device according to any of claims 1 to 5, wherein said means for generating said multipolar magnetic cusp field comprise an assembly of permanent magnets and/or electromagnets covering the exterior side of said wall (13) with respect to the treatment zone.

7. Device according to any of claims 1 to 6, wherein said wall (13) is a metal wall (13) presenting electrical insulation (14) at the exterior side with respect to the treatment zone.

8. Device according to any of claims 1 to 7, wherein said confinement enclosure (15) has two opposite walls (13) extending parallel to said transport direction (5) on opposite sides of the treatment zone, each of these opposite walls (13) forming a plasma diffuser panel.

9. Device according to any of claims 1 to 8, wherein at least one electron source is provided in the treatment zone for controlling the density of the plasma in the treatment zone.

10. Device according to claim 9, wherein at least one plasma current measurement probe (20a, 20b) is provided in the treatment zone cooperating with said at least one electron source to control plasma density along a direction transverse to said transport direction (5).

11. Device according to claim 9 or 10, wherein said electron source comprises a hot filament (17) extending preferably along said walls (13) according to said transport direction (5).

12. Device according to any of claims 1 to 11, wherein said confinement enclosure (15) has an entry defined by an entry opening (3) and an exit defined by an exit opening (4) for said substrates, each of said openings (3,4) connecting to a corresponding tubular passage (3a,4a) extending along said transport direction (5) on opposite sides of the treatment zone, wherein said tubular passage (3a,4a) is electrically isolated such as to be maintained at floating potential or is maintained at an electrical potential corresponding to the potential of walls of the vacuum chamber (1).

13. Device according to claim 12, wherein said tubular passages (3a,4a) comprise closing means for decreasing the distance transversal to the transport direction (5) between the tubular passage and the substrates to be moved through the passage.

14. Device according to any of claims 1 to 13, wherein said confinement enclosure (15) presents at least one pumping port (10) for evacuating gas from said confinement enclosure (15) towards said vacuum chamber (1), this port (10) presenting an aperture covered by an internal mesh (10a) facing the treatment area and an external mesh (10b) facing the vacuum chamber (1), this external mesh (10b) being provided at the side of the interior mesh (10a) that is exterior with respect to the treatment zone, wherein the internal mesh (10a) is electrically connected to said walls (13) and wherein the external mesh (10b) is maintained at floating potential or at an electrical potential corresponding to the potential of walls of the vacuum chamber (1).

15. Device according to claim 14, wherein the distance between said internal mesh (10a) and said external mesh (10b) is superior to 5 mm.

16. Device according to any of claims 1 to 15, wherein said treatment zone is delimited by closing panels (22) extending transversely with respect to the transport direction (5) on opposite sides of the treatment zone, wherein these closing panels (22) connect to said lateral walls (13) and said means for generating said multipolar magnetic cusp field extend between said closing panels (22) along said at least one lateral wall (13).

17. Device according any of claims 1 to 16, wherein said means for generating said multipolar magnetic cusp field only extend along said lateral walls (13) or along said transport direction (5) over the length of said treatment zone such that a reduction of density of said plasma can be obtained at the opposite sides of the treatment zone along said transport direction (5).

18. Method for plasma treating substrates wherein the substrates (21) are moved along a transport direction (5) through a treatment zone that is delimited in a direction transversal to said transport direction (5) by at least one wall (13) forming a diffuser panel presenting an aperture (23) and wherein plasma is introduced into the treatment zone trough said aperture, which plasma is generated by means of a plasma source connecting to said aperture (23), **characterised in that** a multipolar cusp magnetic field is generated extending along this wall (13) and at least partially around said aperture (23) and adjacent to the aperture (23) such that said plasma entering the treatment zone trough said aperture (23) is distributed along said wall (13) in the treatment zone.

19. Method according to claim 18, wherein density of the plasma in the treatment zone is controlled by generating an electron current by means of at least one electron source (17) in said multipolar magnetic cusp field.

20. Method according to claim 19, wherein plasma current is measured in the treatment zone and said electron current is regulated in function of the measured plasma current for controlling the plasma density along a direction transverse to said transport direction (5).

21. Method according to any of claims 18 to 20, wherein said multipolar cusp magnetic field is generated along said wall (13) and adjacent to the aperture (23) around the complete circumference of the aperture (23).
